# EUROPÄISCHE PATENTSCHRIFT

(11) **EP 0 433 966 B1**
(45) Veröffentlichungstag und Bekanntmachung des Hinweises auf die Patenterteilung: **05.07.1995**
(21) Anmeldenummer: 90124561.3
(22) Anmeldetag: 18.12.1990
(51) Int. Cl.: H02M 5/257

(54) **Verfahren und Schaltungsaufbau zur Ansteuerung von mehreren Triacs**
Method and circuiting for driving a plurality of triacs
Méthode et montage de circuit pour la commande de plusieurs triacs

(30) Priorität: 22.12.1989 DE 3942710
(43) Veröffentlichungstag der Anmeldung: 26.06.1991
(73) Patentinhaber: Bosch-Siemens Hausgeräte GmbH, 81669 München (DE); THE COCA-COLA COMPANY, Atlanta, Georgia 30301 (US)
(72) Erfinder: Striek, Ralf-Jürgen, Dipl.-Ing., W-1000 Belin 13 (DE); Müller, Peter, Dipl.-Ing., W-1000 Berlin 31 (DE)
(74) Vertreter: Rode, Franz

(56) Entgegenhaltungen:
- GB-A- 2 115 240

## Beschreibung

Die Erfindung bezieht sich auf eine Schaltungsanordnung zum dynamischen Zünden von mehreren, durch einen Schaltbefehl miteinander zu schaltenden Triacs, mittels Niederspannungs-Schaltelemente.

Es ist bekannt (GB-A 21 15 240) einen oder mehrere elektrische Verbraucher über Halbleiterbauelemente, z.B. Leistungstriacs, durch eine Ansteuerschaltung anzusteuern, und zwar zur Beaufschlagung mit unterschiedlichen Leistungen, phasenanschnitt-gesteuert.

Leistungstriacs in derartigen Schaltungen werden üblicherweise von einem Auswahl-Zeitgeber gezündet. Diese Abfrage steht mit einer Logik in Verbindung, an deren Eingängen Sensoren oder dgl. angeschlossen sind. Eine solche Steuerschaltung ist vorzugsweise in einem Mikroprozessor, bzw. als Mikroprozessor-Schaltung ausgebildet. Sollen bei der Abfrage eines eingestellten Programms mehrere Triacs gleichzeitig gezündet werden, so ist im Mikroprozessor bzw. für die elektrischen Schaltelemente im Mikroprozessor die Belastung zu hoch, es müssen für den speziellen Fall eigene, in bezug auf die Belastung spezifische Niederspannungs-Schaltelemente hergestellt und diese in einem Kanaltreiber zusammengefaßt werden. Eine derartige Anordnung und Gestaltung ist zeit- und materialaufwendig.

Bei der Ansteuerung von Triacs sind prizipiell zwei Verfahren bekannt, und zwar die "statische" Ansteuerung und die "dynamische" Ansteuerung, letztere auch "Impulssteuerung" genannt. Beim Impulsbetrieb in Wechselstromnetzen wird im Mittel weniger Energie benötigt, es muß jedoch die Information des "Nulldurchganges" vorhanden sein, um ein zu frühes oder zu spätes Zünden der Triacs zu verhindern. Weiterhin muß, bei kapazitiven oder induktiven Lasten die Phasenverschiebung des Stromes berücksichtigt werden, damit der Haltestrom des Triacs nicht unterschritten wird. Beim Einsatz von mehreren Triacs in einem System müssen im Niederspannungs-Netzteil die Summe der Zündströme als Spitzenlast bereitstellen, wenn alle Triacs gleichzeitig gezündet werden.

Um eine Überlastung der Niederspannungs-Schaltteile zu verhindern, wird daher gemäß der Erfindung eine Schaltungsanordnung mit den Merkmalen des Anspruches 1 vorgeschlagen. Durch den Schaltbefehl werden die einzelnen Zündimpulse zeitlich versetzt, wobei man zunächst - wie bekannt - den Nulldurchgang der Spannung ermittelt - und sodann die Zündimpulsfolge selbsttätig startet. Dabei kann man die Zündimpulsfolge während einer Halbwelle des Wechselstromes beliebig oft wiederholen.

Die Steuerschaltung zum dynamischen Zünden mehrerer Triacs, bei der zunächst der Null-Durchgang des Wechselstromes ermittelt wird, besitzt einen Symmetrie-Impulsformer, er kann Bestandteil des Mikroprozessors sein. Eine Logik an der u.a. Sensoren angeschlossen sind, arbeitet mit dem Symmetrie-Impulsformer zusammen. Vorteilhaft ist es, wenn mit dem Symmetrie-Impulsformer auch eine Verzögerungsschaltung zusammenarbeitet. Letztere Schaltung dient dazu, bei durch induktive Lasten nacheilendem Strom (cosφ ) die Zündimpulse zum Stromverlauf hin zu versetzen. Eine Rechnereinheit und eine Abfrage arbeitet mit dem Symmetrie- und Impulsformer ebenfalls zusammen. Die Abfrage ist dem Symmetrie-- und Impulsformer meist vorgeschaltet; sie ist vorteilhaft als Tasten-Multiplex-Schalteinheit ausgebildet. Der Symmetrie- und Impulsformer ist elektrisch mit einem n-Kanaltreiber für die Triacs verbunden. Eine Torschaltung, welche ebenfalls in der Zentraleinheit gelegen sein kann, wird von der Abfrage beeinflußt und schaltet nur jene Zündimpulse zum Kanaltreiber durch, für die Triacs, welche durch die Tasten-MultiplexSchalteinheit geschaltet wurden. Der Symmetrie-Impulsformer, die Logik, der Rechner und die Verzögerungs-Schaltung können in einem Baustein, z.B. in einem Mikroprozessor zusammengefaßt sein und so eine zentrale Schalteinheit bilden.

Die serielle Zündung der Triacs bewirkt somit ein nahezu gleichzeitiges Zünden der durch die Torschaltung ausgewählte Triacs, wobei jedoch im Niederspannungsteil die Strombelastung nur jeweils der Zündung eines einzelnen Triacs entspricht. Eine Überlastung der Schaltelemente innerhalb des Niederspannungsteiles ist somit ausgeschlossen.

In den Zeichnungen ist das Verfahren sowie Schaltungs-Aufbau zum Zünden der Triacs beispielsweise und schematisch dargestellt. Es zeigen:
- Fig. 1: ein Spannungsdiagramm,
- Fig. 2: den einfachen Aufbau einer Schaltung zur Durchführung des Verfahrens
- Fig. 3: eine ähnliche Schaltung gemäß Fig. 2, jedoch in einem Schaubild in expliziter Ausführungsform.
- Fig. 4: eine Abwandlung der Schaltung gemäß Fig. 2.

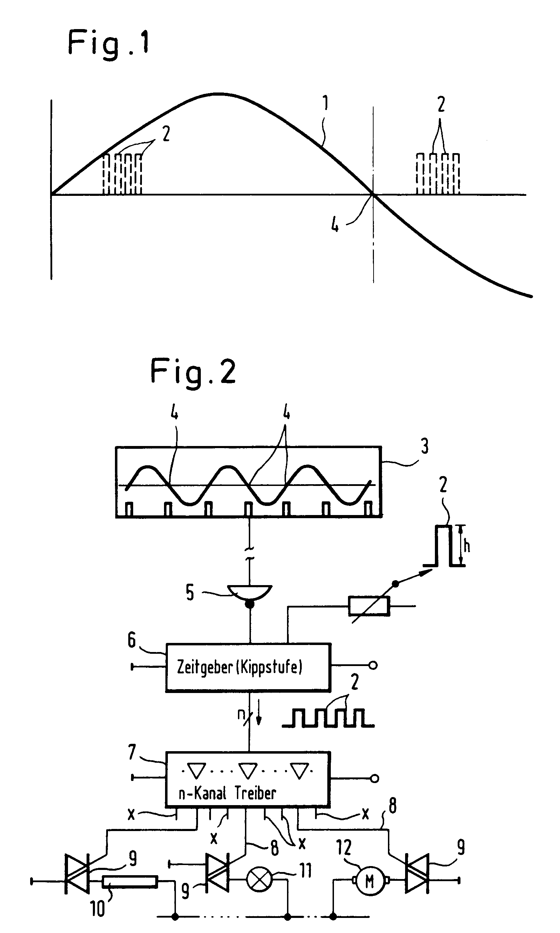

In Fig. 1 ist in einem Diagramm der Spannungsverlauf in Form einer Kurve 1 dargestellt. Befinden sich in einem Gerät mehrere Triacs, die durch einen Schaltbefehl gezündet werden sollen, so werden letztere durch eine Serie von Zündimpulsen 2 gezündet. Diese Zündimpulsfolge kann innerhalb der positiven Halbwelle beliebig oft wiederholt werden. Hier werden die Triacs durch eine Steuereinrichtung, wie nachfolgend beschrieben, kurzzeitig versetzt mit je einem Impuls gezündet, derart, daß die Spitzenlast nur dem Maximalwert des höchsten Zündstromes eines einzelnen Triacs entspricht.

Wie insbesondere aus Fig. 2 hervorgeht, ist in einem Kästchen 3 ebenfalls die Spannungskurve eine Wechselstromes dargestellt. Wichtig ist es, daß zunächst der Nulldurchgang 4 ermittelt wird. Ein Dedektor 5 gibt beim Spannungs-Nulldurchgang ein Signal auf einen Zeitgeber oder Kippstufe 6. Im Zeitgeber wird u.a. die Flankenhöhe h der Impulse zum Zünden der Triacs eingestellt und die Serie festgelegt. Die vom Zeitgeber ausgegebenen Impulse gelangen in den n-Kanaltreiber 7. Im Kanaltreiber werden die Zündimpulse verstärkt und zu den Ausgängen 8 geleitet. An ihnen liegen auch die Leistungstriacs 9. Am n-Kanaltreiber 7 sind weitere Ausgänge x für Leistungstriacs, die im vorliegenden Beispiel nicht gezeigt oder auch für ein Programm nicht benötigt werden. Die Leistungstriacs schalten z.B. eine Heizung 10, eine Leuchte 11 oder einen Motor 12. Es versteht sich, daß auch andere Leistungselemente an den Triacs 9 angeschlossen sein können.

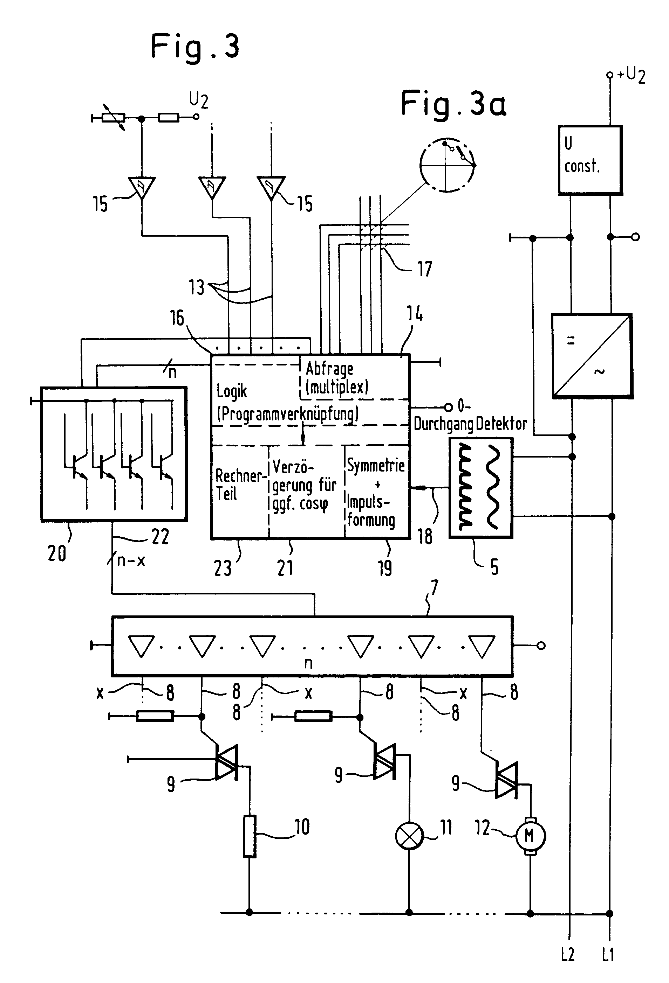

Fig. 3 zeigt eine der Fig. 2 ähnliche Schaltung zum Zünden mehrerer Triacs. Der Zeitgeber oder die Kippstufe 6 in Fig. 2 ist hier ersetzt durch eine Zentraleinheit 14 in der eine Mehrzahl von Schalteinheiten vereinigt sind und auch zusammenarbeiten; die Zentraleinheit ist vorzugsweise als Mikroprozessor gebildet, an ihr sind die Sensoren 15 über ihre Signalleitungen 13 angeschlossen. Die Sensor-Signale gelagen in eine Logik bzw. Programmverknüpfung 16 der Zentraleinheit.

Eine Abfrage bzw. Multiplex-Schaltung 17, bestehend aus mehreren Schalter n Fig. 3a,steht ebenfalls mit der Zentraleinheit 14 in Verbindung. Der Nulldurchgang der Wechselstromspannung wird durch einen Detektor 5 ermittelt, wobei hier der Ausgang des Detektors 18 am Symmetrie- und Impulsformer 19 der Zentraleinheit gelegen ist. Die Zentraleinheit 14 ist mit einer Torschaltung 20 verbunden. Die von der Zentraleinheit ausgegebenen Zündimpulsserie gelangt in die Torschaltung; von hier werden nur jene Zündimpulse über die Signalleitung 22 an den n-Kanaltreiber 7 weitergeleitet, an jene Triacs 9, welche für das an der Abfrage 17 eingeschaltete Programm benötigt werden. Alle anderen Zündimpulse werden unterdrückt, es sind dies z.B. die Ausgänge 8x am n-Kanaltreiber 7. Die Ausgänge x am Signaltreiber 7 führen zu hier nicht dargestellten Triacs, die für das laufende, bei 17 eingestellte Programm nicht benötigt werden. Der Signaltreiber 7 liegt ebenfalls am Niederspannungs-Gleichstromnetz. In ihm werden die Zündimpulse für die Triacs bereitgestellt. Hier kann es, wenn mehrere Triacs gleichzeitig gezündet werden sollen, zu einer Überlastung der Niederspannungs-Bauelemente kommen, das soll verhindert werden. Bedingt dadurch, daß nunmehr die Triacs nacheinander in einer Serie gezündet werden, entspricht die elektrische Zündlast auch nur der eines einzelnen Triacs. Eine Überlastung und damit eine Schädigung der Schaltelemente im Signaltreiber oder in der Zentraleinheit 14 wird somit vermieden. Die Zentraleinheit besitzt vorteilhaft auch eine Signal-Verzögerungsschaltung 21; diese Schaltung dient dazu, bei induktiver Belastung nacheilendem Strom die Zündimpulsserie 2 auf den Stromverlauf auszurichten, um so das Zünden der Triacs zu sichern. Ein in der Zentraleinheit eingebauter Rechner 23 dient zum Koordinieren der einzelnen Befehle mit den Sensoren-Signale und des vom Null-Durchgangsdetektor gelieferten Startsignals. Der Rechner ermittelt auch die Flankenhöhe der Impulse sowie den Auslösezeitpunkt der Impulsserie zum Zünden der Triacs nach erfolgtem NullDurchgang der positiven Halbwelle des Wechselstromes.

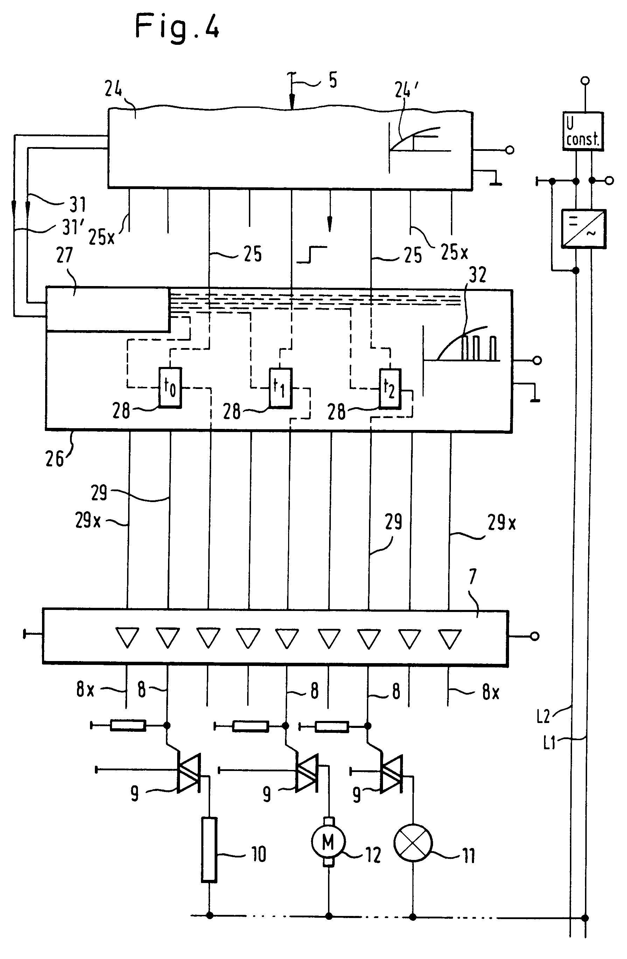

Eine der Fig. 2 ähnliche und vereinfachte Schaltung zum Zünden mehrerer Triacs ist in Fig. 4 schematisch dargestellt. Nachdem vom Null-Detektor 5 der Null-Durchgang des Wechselstromes ermittelt wurde, wird der Mikro-Prozessor 24 geschaltet; er entspricht in seinem Aufbau etwa dem oberen Teil - bis zur durchgehend gestrichelten Linie - dem Mikro-Prozessor 14 in Fig. 3. Der Mikro-Prozessor liefert einen gleichförmigen Startimpuls; wie bei 24' gezeigt. Der Startimpuls gelangt über Signalverbindungen 25 und 25' an Zeitglieder 28 in einem Impulsformer 26. Von einem Rechner oder einem Schieberegister 27 - welches ebenfalls über Verbindungsleitungen 31 und 31' - vom Mikroprozessor gestartet wird, werden die Zeitglieder aktiviert, so daß sie den vom Rechner oder Schieberegister gelieferten Impuls weiterleiten, jedoch in unterschiedlichen Zeiten tₒ, t₁, usw. und zwar derart, daß sich die Impulse - wie bei 32 gezeigt - nicht überlappen. Die Bauteile 24, 27 und 28 sind handelsüblich und dem Durchschnittsfachmann bekannt; sie können aus den Katalogen verschiedener Hersteller entnommen werden. Wesentlich für die Erfindung ist es, daß die zeitliche Versetzung der einzelnen Impulse so vorgenommen wird, daß sie alle innerhalb einer Halbwelle des Wechselstromes liegen und ggf. auch innerhalb dieser Halbwelle wiederholt werden können. Die in Fig. 4 nicht dargestellte Abfrage 17 und Sensoren 15 (Fig. 3) würde auch hier auf den Mikro-Prozessor 24 einwirken und nur jene Triacs 9 für das jeweilig geschaltete Programm bereitstellen, die zu einer Durchführung benötigt werden; alle anderen Triacs, die z.B. die über Signalverbindungen 25x geschaltet werden, sind abgeschaltet. Die von den Zeitgliedern 28 ausgehenden Impulse gelangen über die Signalleitungen 29 und 29x an den n-Kanaltrieber 7 und von dort über die Ausgänge 8 und 8x an die Triacs 9.

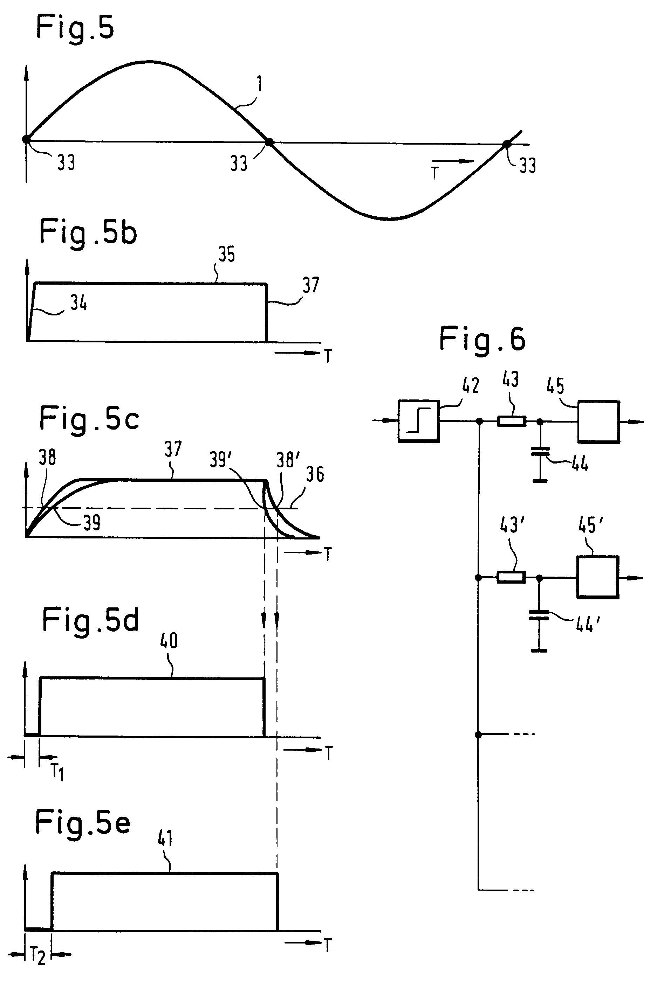

Eine alternative Schaltung zum Zünden mehrerer Triacs zeigen die Figuren 5 und 6, wobei hier die Schaltung unter Verwendung von diskreten Elementen gebildet ist. Im nachfolgenden werden beide Figuren gemeinsam besprochen. Beim Null-Durchgang 33 der Wechselstrom-Netzschwingungen 1 (Fig. 5) schaltet ein Komparator 42 (Fig. 6) das Signal 35 (Fig. 5b) zu den Zeitglieder 43 und 44 durch. Das Signal verformt sich; die An- und Abstiegsflanken des Signals 37 sind gerundet (Fig. 5c). Dieses Signal liegt an einem Schwellwert-Schalter 45 (Fig. 6) an. Ist z.B., der Schwellwert bei 38 (Fig. 5c) erreicht, so schaltet der Schwellwertschalter den anliegenden Impuls durch, der sodann an den n-Kanaltreiber 7 (hier nicht dargestellt) gelangt. Die Zeitglieder 43' und 44' haben eine andere Charakteristik als 43 und 44, ihre Signalform ist durch die Schwellwerte 39 und 39' gekennzeichnet, sie liegen zeitlich versetzt zu den Schwellwerten 38 und 38'. Das am Schwellwertschalter 45' anliegende Signal bzw. der Impuls wird auch - wie schon vorgeschrieben - durchgeschaltet. Am Ausgang der Schwellwertschalter, die z.B. als Schmittrigger gebildet sein können, erhält man unverbindliche Signale. Sie unterscheiden sich von den jeweils anderen Signalen durch die Größe T₁ bzw. T₂, wie Fig. 5d und 5e zeigen. Man hat es so in der Hand, den Zündpunkt der einzelnen Triacs 9 nacheinander festzulegen.

Es versteht sich, daß die Schaltung je nach Art ihres Aufbaues in mannigfacher. Art abänderbar ist; wesentlich ist nur, daß die Schaltung geeignet ist, nach dem Start innerhalb einer Halbwelle des Wechselstromes die im Gerät enthaltenen und ausgewählten Triacs in Serie, d.h. zeitlich nacheinander zu zünden.

## Patentansprüche

1. Schaltungsanordnung zum dynamischen Zünden von mehreren, durch einen Schaltbefehl miteinander zu schaltenden Triacs, mittels Niederspannungs-Schaltelemente, **dadurch gekennzeichnet**, daß der Schaltbefehl einer Zündimpulsfolge-Steuerung (6,7,14,24,26) zugeführt wird, deren mit Zündimpulsen beaufschlagte Ausgänge mit den Steuereingängen der Triacs unmittelbar oder über Verstärker in Verbindung stehen wobei die Zündimpulse ausgehend vom ermittelten Null-Durchgang der Spannung zeitlich versetzt innerhalb einer Halbwelle (1) des Wechselstromes kurz hintereinander erzeugt werden, so daß die Triacs in Serie nacheinander gezündet werden und die elektrische Belastung der Niederspannungs-Schaltelemente beim Zünden der Triacs der Zündbelastung eines einzelnen Triacs entspricht.

2. Schaltungsanordnung nach Anspruch 1, dadurch gekennzeichnet, daß die Zündimpulsfolge-Steuerung innerhalb der Halbwellen (1) wiederholt Zündimpulse abgibt.

3. Steuerschaltung nach einem der Ansprüche 2 bis 3, dadurch gekennzeichnet, daß zum Ermitteln des Null-Durchgangs der Netzspannung ein Symmetrie-Impulsformer angeordnet ist.

4. Steuerschaltung nach Anspruch 3, dadurch gekennzeichnet, daß der Symmetrie- und Impulsformer (19) mit einer Logik (16) in einer Zentraleinheit 14 zusammenarbeitet.

5. Steuerschaltung nach Anspruch 3, dadurch gekennzeichnet, daß mit dem Symmetrie- und Impulsformer (19) auch eine Verzögerungsschaltung (21) zusammenarbeitet, wobei letztere Schaltung (21) bei durch induktive Lasten nacheilendem Strom (cosφ) die Zündimpulsfolge (2) zum Stromverlauf hin versetzt.

6. Steuerschaltung nach Anspruch 3, dadurch gekennzeichnet, daß der Symmetrie- und Impulsformer (19) mit der Logik (16) einem n-Kanaltreiber (7) für die Triacs (9) vorgeschaltet ist.

7. Steuerschaltung nach Anspruch 3, dadurch gekennzeichnet, daß der Symmetrie- und Impulsformer (19) eine Abfrage (17) vorgeschaltet ist.

8. Steuerschaltung nach Anspruch 4, dadurch gekennzeichnet, daß an der Logik (16) auch die Sensoren (15) angeschlossen sind.

9. Steuerschaltung nach Anspruch 7, dadurch gekennzeichnet, daß mit der Abfrage (17) ein Tasten-Multiplex verbunden ist.

10. Steuerschaltung nach einem der Ansprüche 5 bis 10, dadurch gekennzeichnet, daß eine Torschaltung (20) zur Auswahl der parallel zu aktivierenden Triacs (9) mit der Zentraleinheit (14) elektrisch verknüpft ist.

11. Steuerschaltung nach Anspruch 4, dadurch gekennzeichnet, daß zumindest ein Teil der Schaltungen (19 bis 23) innerhalb der Zentraleinheit (14), die als Mikroprozessor-Schaltung ausgebildet ist, vereinigt sind.

12. Steuerschaltung nach einem der vorstehenden Ansprüche 4 bis 11, dadurch gekennzeichnet, daß sie eine der Anzahl der im Gerät enthaltenden Triacs (9) gleiche Anzahl von Zeitgliedern (28; 43, 44 usw.) ein Schwellwertschalter (45) nachgeschaltet ist.

13. Steuerschaltung nach Anspruch 12, dadurch gekennzeichnet, daß am R-C-Zeitgeber (43, 44) ein Komparator (42) vorgeschaltet und allen Zeitgliedern (43, 44 + 43' 44' usw.) ein Schwellwertschalter (45) nachgeschaltet ist.

14. Steuerschaltung nach Anspruch 12 oder 13, dadurch gekennzeichnet, daß die Schwellwertschalter (45) dem n-Kanaltreiber (7) vorgeschaltet sind.

15. Steuerschaltung nach einem oder mehreren der vorstehenden Ansprüche 12 bis 14, dadurch gekennzeichnet, daß allen Zeitgliedern (43, 44 + 43′, 44′ usw.) ein gemeinsamer Komparator (42) vorgeschaltet ist.

16. Steuerschaltung nach einem oder mehreren der vorstehenden Ansprüche 11 bis 15, dadurch gekennzeichnet, daß Zeitglieder (28) ihren Zündimpuls (24) vom Mikro-Prozessor (24) erhalten und diese Zeitglieder (28) von einem Schieberegister (27) zu den Eingängen des n-Kanaltreibers (7) durchgeschaltet werden.

## Claims

1. Circuit arrangement for the dynamic ignition of several triacs, which are to be switched together by a switching command, by means of low-voltage switch elements, characterised thereby, that the switching command is fed to an ignition pulse sequence control (6, 7, 14, 24, 26), the outputs of which are acted on by ignition pulses and stand in connection with the control inputs of the triacs either directly or by way of amplifiers, wherein the ignition pulses are produced starting out from the ascertained zero transition of the voltage one displaced in time shortly behind the other within one half-wave (1) of the alternating current so that the triacs are ignited in sequence one behind the other and the electrical loading of the low-voltage circuit elements during the ignition of the triacs amounts to the ignition loading of a single triac.

2. Circuit arrangement according to claim 1, characterised thereby, that the ignition pulse sequence control delivers ignition pulses repeatedly within the half-waves (1).

3. Control circuit according to one of the claims 1 and 2, characterised thereby, that a symmetrical pulse shaper is arranged for ascertaining the zero transition of the mains voltage.

4. Control circuit according to claim 3, characterised thereby, that the symmetry and pulse shaper (19) co-operates with a logic system (16) in a control unit (14).

5. Control circuit according to claim 3, characterised thereby, that the symmetry and pulse shaper (19) also co-operates with a delay circuit (21), wherein the latter circuit (21) displaces the ignition pulse sequence (2) relative to the course of the current in the case of current (cos φ) trailing due to inductive loads.

6. Control circuit according to claim 3, characterised thereby, that the symmetry and pulse shaper (19) together with the logic system (16) is connected in front of an n-channel driver (7) for the triacs (9).

7. Control circuit according to claim 3, characterised thereby, that the symmetry and pulse shaper (19) is connected to follow an interrogation (17).

8. Control circuit according to claim 4, characterised thereby, that the sensors (15) are also connected to the logic system (16).

9. Control circuit according to claim 7, characterised thereby, that a key multiplex is connected with the interrogation (17).

10. Control circuit according to one of the claims 5 to 10, characterised thereby, that a gate circuit (20) for the selection of the triacs (9) to be activated in parallel is electrically interlinked with the central unit (14).

11. Control circuit according to claim 4, characterised thereby, that at least a part of the circuits (19 to 23) are combined within the central unit (14), which is constructed as microprocessor circuit.

12. Control circuit according to one of the preceding claims 4 to 11, characterised thereby, that it is connected to follow a number, which is equal to the number of the triacs (9) contained in the apparatus, of timing members (28; 43, 44 and so forth) and a threshold value switch (45).

13. Control circuit according to claim 12, characterised thereby, that a comparator (42) is connected in front of the resistance-capacitance time generator (43, 44) and a threshold value switch (45) is connected to follow all timing members (43, 44 + 43', 44 and so forth).

14. Control circuit according to claim 12 or 13, characterised thereby, that the threshold value switch (45) is connected in front of the n-channel driver (7).

15. Control circuit according to one or more of the preceding claims 12 to 14, characterised thereby, that a common comparator (42) is connected in front of all timing members (43, 44 + 43', 44 and so forth).

16. Control circuit according to one or more of the preceding claims 11 to 15, characterised thereby, that timing members (28) receive their ignition pulse (24) from the microprocessor (24) and these timing members (28) are switched through by a shift register (27) to the inputs of the n-channel driver (7).

## Revendications

1. Montage pour l'allumage dynamique de plusieurs triacs devant être commutés ensemble par un ordre de commutation, au moyen d'éléments de commutation à basse tension, caractérisé en ce que l'ordre de commutation est envoyé à une unité de commande (6, 7, 14, 24, 26) de séquence d'impulsions d'allumage dont les sorties, auxquelles sont appliquées les impulsions d'allumage, sont reliées, directement ou par l'intermédiaire d'amplificateurs, aux entrées de commande des triacs, les impulsions de commande étant produites, à partir du passage, déterminé, par zéro de la tension, rapidement les unes après les autres, de manière décalée dans le temps pendant une demi-onde (1) du courant alternatif, de sorte que les triacs sont allumés en série les uns après les autres et que la charge électrique des éléments de commutation à basse tension lors de l'allumage des triacs correspond à la charge d'allumage d'un seul triac.

2. Montage selon la revendication 1, caractérisé en ce que l'unité de commande de séquence d'impulsions d'allumage délivre des impulsions d'allumage, de manière répétitive, pendant les demi-ondes (1).

3. Circuit de commande selon l'une des revendications 2 ou 3, caractérisé en ce que l'on prévoit un circuit de mise en forme d'impulsions et de symétrie pour déterminer le passage par zéro de la tension du secteur.

4. Circuit de commande selon la revendication 3, caractérisé en ce que le circuit de mise en forme d'impulsions et de symétrie (19) coopère avec une unité logique (16) dans une unité centrale (14).

5. Circuit de commande selon la revendication 3, caractérisé en ce qu'un circuit de retard (21) coopère aussi avec le circuit de mise en forme d'impulsions et de symétrie (19), ce circuit de retard (21) décalant, pour un courant (cos φ) en retard de phase à cause de charges inductives, la séquence d'impulsions d'allumage (2) vers le trajet du courant.

6. Circuit de commande selon la revendication 3, caractérisé en ce que le circuit de mise en forme d'impulsions et de symétrie (19) avec l'unité logique (16) est branché en amont d'un circuit d'attaque à canal n (7) pour les triacs (9).

7. Circuit de commande selon la revendication 3, caractérisé en ce qu'une unité d'interrogation (17) est branchée en amont du circuit de mise en forme d'impulsions et de symétrie (19).

8. Circuit de commande selon la revendication 4, caractérisé en ce que l'on raccorde aussi à l'unité logique (16) les capteurs (15).

9. Circuit de commande selon la revendication 7, caractérisé en ce qu'un système de multiplexage à touches est relié à l'unité d'interrogation (17).

10. Circuit de commande selon l'une des revendications 5 à 10, caractérisé en ce qu'un circuit porte (20) est relié de façon électriquement conductrice à l'unité centrale (14) pour effectuer la sélection des triacs (9) devant être activés en parallèle.

11. Circuit de commande selon la revendication 4, caractérisé en ce qu'au moins une partie des circuits (19 à 23) est combinée à l'intérieur de l'unité centrale (14) qui est conçue sous la forme d'un circuit à microprocesseur.

12. Circuit de commande selon l'une des revendications précédentes 4 à 11, caractérisé en ce qu'elle contient un nombre de relais temporisateurs (28 43, 44, etc.) qui est égal au nombre de triacs (9) contenus dans le dispositif.

13. Circuit de commande selon la revendication 12, caractérisé en ce qu'un comparateur (42) est branché en amont du générateur de cadence de type R-C (43, 44) et en ce qu'un interrupteur à valeur de seuil (45) est branché en aval de tous les relais temporisateurs (43, 44 + 43' 44′, etc.).

14. Circuit de commande selon l'une des revendications 12 ou 13, caractérisé en ce que l'interrupteur à valeur de seuil (45) est branché en amont du circuit d'attaque à canal n (7).

15. Circuit de commande selon une ou plusieurs des revendications précédentes 12 à 14, caractérisé en ce qu'un comparateur commun (42) est branché en amont de tous les relais temporisateurs (43, 44 + 43′, 44′ etc.).

16. Circuit de commande selon une ou plusieurs des revendications précédentes 11 à 15, caractérisé en ce que les relais temporisateurs (28) reçoivent leur impulsion d'allumage (24) à partir du microprocesseur (24) et en ce que ces relais temporisateurs (28) sont reliés par un registre à décalage (27) aux entrées du circuit d'attaque à canal n (7).
